(19) **Europäisches Patentamt / European Patent Office / Office européen des brevets**

(11) **EP 2 775 614 A2**

(12) # EUROPÄISCHE PATENTANMELDUNG

(43) Veröffentlichungstag:
10.09.2014 Patentblatt 2014/37

(51) Int Cl.:
**H03H 11/12** (2006.01)     **H03H 11/28** (2006.01)
**F16F 15/00** (2006.01)     **G05D 19/02** (2006.01)

(21) Anmeldenummer: **14157614.0**

(22) Anmeldetag: **04.03.2014**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(30) Priorität: **04.03.2013 DE 102013102090**

(71) Anmelder: **Deutsches Zentrum für Luft- und Raumfahrt e.V.**
**51147 Köln (DE)**

(72) Erfinder:
• **Pohl, Martin**
**38108 Braunschweig (DE)**
• **Monner, Dr. Hans Peter**
**38527 Meine (DE)**

(74) Vertreter: **Günther, Constantin**
**Gramm, Lins & Partner GbR**
**Freundallee 13a**
**30173 Hannover (DE)**

(54) **Semiaktives Schwingungsdämpfungselement**

(57) Die Erfindung betrifft ein semiaktives Schwingungsdämpfungselement zur Dämpfung mechanischer Schwingungen, das wenigstens einen elektromechanischen Wandler (1), der zum Wandeln mechanischer Schwingungen in ein elektrisches Signal eingerichtet ist, und wenigstens eine elektronische Schaltung (2) aufweist, die elektrisch mit dem elektromechanischen Wandler (1) verbunden ist und zur Aufnahme des vom elektromechanischen Wandler (1) aufgrund von mechanischen Schwingungen abgegebenen elektrischen Signals eingerichtet ist, wobei die elektronische Schaltung (2) dazu eingerichtet ist, den elektromechanischen Wandler (1) mit einem aufgrund des elektrischen Signals des elektromechanischen Wandlers (1) generierten elektrischen Beaufschlagungssignal zu beaufschlagen, wobei das Beaufschlagungssignal einen Gleichspannungsanteil aufweist, der ungleich null Volt ist.

Fig. 1

EP 2 775 614 A2

**Beschreibung**

Die Erfindung betrifft ein semiaktives Schwingungsdämpfungselement gemäß dem Oberbegriff des Anspruchs 1.

Es gibt in vielen Bereichen der Technik einen Bedarf an schwingungsdämpfenden Maßnahmen, z. B. zur Schalldämmung und/oder zur Vibrationsunterdrückung. Insbesondere auf Grund moderner Leichtbaustrukturen von technischen Gegenständen, z. B. Straßen- und Luftfahrzeugen, besteht ein steigender Bedarf an effizienten Schwingungsdämpfungsmaßnahmen. Die Leichtbaustrukturen, oft verbunden mit dem Einsatz faserverstärkter Kunststoffe in Form von Integralbauweisen, vereinen eine hohe Steifigkeit des Materials bei geringer Masse. Dadurch resultieren jedoch eine reduzierte inhärente Schalldämmung und eine höhere Schwingungsneigung gegenüber konventionellen, massiveren Bauweisen.

Bekannte Maßnahmen der Lärm- und Vibrationsunterdrückung lassen sich grob in drei Bereiche einteilen:

1. Passive Verfahren, z. B. die Verwendung mechanischer Dämpfer, viskoelastischer Schichten oder mechanischer Tilgersysteme.

2. Aktive Schwingungsdämpfung durch Nutzung elektromechanischer, insbesondere adaptronischer Komponenten, d. h. Sensoren, Aktoren, Datenverarbeitungsmittel und in der Regel Leistungselektronik. Durch Systeme wie Active Vibration Control oder Active Noise Control können Schwingungen beeinflusst und insbesondere aktiv gedämpft werden.
Der bei solchen aktiven Schwingungsdämpfungsverfahren zu betreibende Aufwand und die damit verbundenen Kosten sind relativ hoch. Allerdings ist die Wirksamkeit bei der Schwingungsbedämpfung auch erheblich besser als bei den rein passiven Verfahren.

3. Gegenüber den rein passiven mechanischen Verfahren zur Schwingungsdämpfung wurden zur Verbesserung elektromechanische Wandler, z. B. in Form piezoelektrischer Elemente, vorgeschlagen, bei denen die Dämpfungswirkung durch daran angeschlossene passive elektrische Netzwerke erfolgt. Solche Schwingungsdämpfungselemente sind flexibler einzusetzen als die rein passiven mechanischen Verfahren, erreichen aber nicht die Effizienz der aktiven Schwindungsdämpfung. Als weitere Verbesserung wurden z. B. in US 4,158,787 oder US 5,558,477 Maßnahmen zur Schwingungsdämpfung mit elektromechanischen Wandlern vorgeschlagen, die mit semiaktiven Netzwerken gekoppelt sind. Eine solche Anordnung aus elektromechanischem Wandler und semiaktivem elektrischen Netzwerk wird auch als semiaktives Schwingungsdämp-fungselement bezeichnet. Hierbei weist das semiaktive Netzwerk eine elektronische Schaltung auf, die neben passiven Bauelementen auch Halbleiterbauelemente, z. B. Operationsverstärker, aufweist. Solche semiaktiven Schwingungsdämpfungselemente sind vom Aufwand und den Kosten her ebenfalls erheblich günstiger zu realisieren als aktive Schwingungsdämpfungsmaßnahmen, können aber durch geeignete Ausbildung der elektronischen Schaltung erheblich effizienter Schwindungen bedämpfen als rein passive mechanische oder elektrische Schwingungsdämpfungsmaßnahmen.

Der Erfindung liegt die Aufgabe zugrunde, ein semiaktives Schwingungsdämpfungselement anzugeben, das hinsichtlich seiner Wirksamkeit bei der Dämpfung von mechanischen Schwingungen gegenüber den zuvor genannten Vorschlägen mit wenig Aufwand deutlich verbessert ist.

Diese Aufgabe wird gemäß Anspruch 1 gelöst durch ein semiaktives Schwingungsdämpfungselement zur Dämpfung mechanischer Schwingungen, das wenigstens einen elektromechanischen Wandler, der zum Wandeln mechanischer Schwingungen in ein elektrisches Signal eingerichtet ist, und wenigstens eine elektronische Schaltung aufweist, die elektrisch mit dem elektromechanischen Wandler verbunden ist und zur Aufnahme des vom elektromechanischen Wandler aufgrund von mechanischer Schwingungen abgegebenen elektrischen Signals eingerichtet ist, wobei die elektronische Schaltung dazu eingerichtet ist, den elektromechanischen Wandler mit einem aufgrund des elektrischen Signals des elektromechanischen Wandlers generierten elektrischen Beaufschlagungssignal zu beaufschlagen, wobei das Beaufschlagungssignal einen Gleichspannungsanteil aufweist, der ungleich null Volt ist. Die Erfindung hat den Vorteil, dass durch die Ausbildung der elektronischen Schaltung derart, dass der elektromechanische Wandler mit einem Beaufschlagungssignal beaufschlagt werden kann, dessen Gleichspannungsanteil (bzw. Gleichanteil) ungleich null Volt ist, der elektromechanische Wandler erheblich wirksamer zur Schwingungsdämpfung angesteuert werden kann als bisher. Untersuchungen haben gezeigt, dass für eine praktische Schwingungsdämpfung geeignete elektromechanische Wandler, insbesondere piezoelektrische Elemente, einen bezüglich null Volt unsymmetrischen Betriebsspannungsbereich aufweisen, z. B. - 500 bis + 2000 Volt pro Millimeter Dicke des Piezokristalls. Durch Ausbildung der elektronischen Schaltung derart, dass der elektromechanische Wandler mit einem Gleichanteil ungleich null des zeitvariablen Beaufschlagungssignals beaufschlagt wird, kann durch geeignete Wahl des Gleichanteils der Arbeitsbereich der elektronischen Schaltung an den Betriebsspannungsbereich des elektromechanischen Wandlers angepasst werden. Vorteilhaft ist es, die elektronische Schaltung derart auszubilden, dass das Beaufschlagungssignal mit einem Gleichspannungsanteil erzeugt wird, der genau in der Mitte des Betriebsspannungsbereichs des elektromechanischen Wandlers liegt. Dann ist eine symmetrische Ansteuerung des elektromechanischen Wandlers bei voller Ausnutzung von dessen Betriebsspannungsbereich möglich.

Gegenüber bekannten Vorschlägen, bei denen ein differenzieller Verstärker der elektronischen Schaltung mit demselben Bezugspotential (Massepotential) betrieben wird wie der elektromechanische Wandler, kann bei dem erfindungsgemäßen semiaktiven Schwingungsdämpfungselement vorgesehen sein, dass der elektromechanische Wandler mit einem Anschluss auf ein anderes Bezugspotential (Extra-Massepotential) geschaltet ist, z. B. indem die Schaltungsanordnung aus dem wenigstens einen elektromechanischen Wandler und der elektronischen Schaltung mit vier unterschiedlichen elektrischen Potentialen zur elektrischen Energieversorgung verbunden wird.

Ein weiterer Vorteil der Erfindung besteht darin, dass im Vergleich zu aktiven Schwingungsdämpfungsmaßnahmen eine relativ einfach aufgebaute elektronische Schaltung verwendet werden kann, die insbesondere keinen elektronischen Regler und keine digitale Signalverarbeitung erfordert. Es sind auch keine zusätzlichen Sensoren erforderlich, wie sie bei aktiven Schwingungsdämpfungsmaßnahmen notwendig sind. Zudem muss kein exaktes Strukturmodell des Regelkreises zur Umsetzung im digitalen Regler erstellt werden. Die elektronische Schaltung des erfindungsgemäßen semiaktiven Schwingungsdämpfungselements kann z. B. rein analog realisiert werden. Eine Realisierung der elektronische Schaltung des erfindungsgemäßen semiaktiven Schwingungsdämpfungselements mit digitalen Bauelementen ist auch möglich.

Gegenüber passiven Schwingungsdämpfungsmaßnahmen ist die Wirksamkeit der Schwingungsbedämpfung erheblich verbessert. Zudem kann über einen größeren Frequenzbereich eine effiziente Dämpfung der Schwingungen erfolgen. Je nach Auslegung der elektronischen Schaltung erlaubt die Erfindung eine relativ breitbandige Schwingungsdämpfung, bis hin zu Frequenzen von einigen Kilohertz. Dies ist übrigens auch ein Vorteil gegenüber aktiven Schwingungsdämpfungsmaßnahmen, die digitale Regler verwenden. Digitale Regler lassen sich nach dem derzeitigen Stand der Technik nicht oder nur mit großem technischen Aufwand so realisieren, dass auch eine Schwingungsdämpfung in den Bereich mehrerer Kilohertz möglich wird.

Das erfindungsgemäße semiaktive Schwingungsdämpfungselement kann z.B. derart eingesetzt werden, dass der elektromechanische Wandler mit einer mechanischen Struktur, d. h. irgendeinem Bauteil, dessen Schwingungen zu bedämpfen sind, mechanisch verbunden wird. Die elektronische Schaltung wird in der Regel mechanisch entkoppelt vom elektromechanischen Wandler an anderer Stelle angeordnet, vorteilhaft in der Nähe des elektromechanischen Wandlers. Über den elektromechanischen Wandler wird Schwingungsenergie aus dem oszillierenden mechanischen System in ein elektrisches System überführt, d. h. an die elektronische Schaltung abgegeben, und dort in irgendeiner Weise dissipiert. Hierdurch kann eine Vibrations- und Schallreduktion erreicht werden. In der Praxis ist es vorteilhaft, eine Vielzahl solcher semiaktiven Schwingungsdämpfungselemente an der zu bedämpfenden Struktur anzuordnen, z. B. über einen gewissen Flächenbereich gleichmäßig oder ungleichmäßig verteilt. Die einzelnen elektronischen Schaltungen der Vielzahl der semiaktiven Schwingungsdämpfungselemente können dann als Einzelschaltungsbaugruppen realisiert werden, zu mehreren Schaltungen je Baugruppe gruppiert oder einer einzigen Baugruppe zusammengefasst werden. Es können z. B. verteilte lokale Gruppenplatinen mit mehreren elektronischen Schaltungen mehrerer semiaktiver Schwingungsdämpfungselemente oder eine zentrale Platine mit sämtlichen elektronischen Schaltungen realisiert werden. Dies kann je nach Anwendung und verfügbarem Bauraum fallweise ausgewählt werden.

Vorteilhaft ist weiterhin, dass der elektromechanische Wandler zugleich als Sensor als auch als Aktuator des Schwingungsdämpfungselements wirksam sein kann. Damit sind zusätzliche Sensoren zur Sensierung der mechanischen Schwingungen nicht erforderlich.

Als Gleichspannungsanteil des Beaufschlagungssignals wird diejenige Spannung des Beaufschlagungssignals angesehen, die über die Zeit gemittelt vorliegt. Der Gleichspannungsanteil kann z.B. durch Spannungsmessung am elektromechanische Wandler gemessen werden, wenn elektromechanische Wandler nicht mit mechanischen Schwingungen beaufschlagt ist bzw. nicht ausgelenkt ist.

Zur Realisierung der Erfindung können alle Arten von elektromechanischen Wandlern eingesetzt werden, die mechanische Schwingungen in ein elektrisches Signal wandeln. Insbesondere können elektromechanische Wandler eingesetzt werden, die mechanische Schwingungen in ein elektrisches Signal und umgekehrt ein elektrisches Signal in mechanische Schwingungen oder eine sonstige mechanische Bewegung wandeln. Gemäß einer vorteilhaften Weiterbildung der Erfindung ist der elektromechanische Wandler als piezoelektrischer Aktuator oder als magnetischer Aktuator, z.B. mit einer Tauchspule, ausgebildet. Der elektromechanische Wandler kann als auf einem induktiven Prinzip beruhender elektromechanischer Wandler ausgebildet sein, z. B. mit einer Tauchspule oder in der Art eines Lautsprechers. Sofern das Schwingungsdämpfungselement mehrere elektromechanische Wandler aufweist, können diese gleichartig oder unterschiedlich sein, z.B. in Form einer Kombination aus piezoelektrischen und magnetischen Aktuatoren.

Gemäß einer vorteilhaften Weiterbildung der Erfindung ist die elektronische Schaltung dazu eingerichtet, das elektrische Beaufschlagungssignal als Dämpfungssignal zu generieren, durch das auf den elektromechanischen Wandler einwirkende mechanische Schwingungen bedämpft sind. Die elektronische Schaltung kann z. B. derart eingerichtet sein, dass sie das Beaufschlagungs-signal um einen gewissen Phasenwinkel phasenverschoben zum vom elektromechanischen Wandler auf Grund von mechanischen Schwingungen abgegebenen elektrischen Signal generiert. Das Beaufschlagungssignal kann z. B. gegenphasig (Phasenverschiebung von 180 Grad) zu dem vom elektromechanischen Wandler abgegebenen elektrischen Signal generiert werden.

Gemäß einer vorteilhaften Weiterbildung der Erfindung weist die Schaltungsanordnung aus dem wenigstens einen elektromechanischen Wandler und der elektronischen Schaltung wenigstens vier getrennte elektrische Energieversorgungsanschlüsse zur elektrischen Energieversorgung der Schaltungsanordnung mit wenigstens vier unterschiedlichen elektrischen Potentialen auf. Dies hat den Vorteil, dass die elektronische Schaltung, die das Beaufschlagungssignal erzeugt, für sich genommen symmetrisch z. B. aus drei der vier elektrischen Potentiale gespeist werden kann und der elektromechanische Wandler an das vierte Potential angeschlossen werden kann. Auf diese Weise kann mit wenig Schaltungsaufwand ein Gleichspannungsanteil des Beaufschlagungssignals in der gewünschten Höhe bereitgestellt werden.

Insbesondere kann vorgesehen sein, dass die elektronische Schaltung drei der genannten vier Energieversorgungsanschlüsse aufweist, um aus dreien der genannten vier Potentiale mit elektrischer Energie versorgt zu werden, und der elektromechanische Wandler mit einem seiner Anschlüsse an die elektronische Schaltung und mit einem anderen seiner Anschlüsse an den vierten Energieversorgungsanschluss angeschlossen ist, um aus dem vierten Potential mit elektrischer Energie versorgt zu werden.

In diesem Fall kann z. B. ein erster elektrischer Energieversorgungsanschluss der vier getrennten elektrischen Energieversorgungsanschlüsse mit einem ersten elektrischen Potential verbunden sein, ein zweiter elektrischer Energieversorgungsanschluss mit einem zweiten elektrischen Potential, ein dritter elektrischer Energieversorgungsanschluss mit einem dritten elektrischen Potential und der vierte elektrische Energieversorgungsanschluss mit dem vierten elektrischen Potential verbunden sein.

Die elektronische Schaltung kann unterschiedlich mit Halbleiterbauelementen ausgestaltet sein. Gemäß einer vorteilhaften Weiterbildung der Erfindung weist die elektronische Schaltung wenigstens einen differenziellen Verstärker auf, der mit einem differenziellen Eingang und einem Ausgang über ein Schaltungsnetzwerk mit einem Anschluss des elektromechanischen Wandlers gekoppelt ist. Das Schaltungsnetzwerk kann insbesondere ein passives Netzwerk sein, das z. B. ohmsche Widerstände, Kondensatoren und/oder Induktivitäten aufweist. Ein differenzieller Verstärker ist ein Verstärker, der über wenigstens zwei differenzielle Eingänge verfügt, wobei ein Ausgangssignal an einem Ausgang des differenziellen Verstärkers bereitgestellt wird, durch das die Differenz der Potentiale der differenziellen Eingänge verstärkt ist. Der differenzielle Verstärker kann z. B. durch ein oder mehrere Operationsverstärker oder entsprechende Transistorschaltungen realisiert werden. Gemäß einer vorteilhaften Weiterbildung der Erfindung weist der differenzielle Verstärker einen Verstärkungsfaktor von wenigstens 1000 auf (Spannungsverstärkungsfaktor). Durch den differenziellen Verstärker können auf einfache und kostengünstige Weise vorteilhafte elektronische Schaltungen realisiert werden, die eine besonders effiziente Schwingungsdämpfung der mechanischen Schwingungen durch das semiaktive Schwingungsdämpfungselement erlauben. Z. B. kann damit ein negatives Kapazitätsnetzwerk realisiert werden.

Gemäß einer vorteilhaften Weiterbildung der Erfindung ist dem differenziellen Verstärker ein Leistungsverstärker nachgeschaltet, der das vom differenziellen Verstärker abgegebene Signal auf höhere Spannungspegel verstärkt. Dies hat den Vorteil, dass der Spannungshub des Beaufschlagungssignals durch die Hinzunahme des Leistungsverstärkers vergrößert werden kann, wobei einfache, handelsübliche elektronische Bauelemente verwendet werden können. So kann z. B. die elektronische Schaltung einen differenziellen Verstärker in Form eines handelsüblichen Operationsverstärkers aufweisen. Handelsübliche Operationsverstärker, die preisgünstig erhältlich sind, werden z. B. mit Betriebsspannungen von +15 Volt/-15 Volt versorgt. In einem entsprechenden Spannungsbereich von +15 Volt bis -15 Volt bewegt sich dann das Ausgangssignal eines solchen Operationsverstärkers. Da elektromechanische Wandler, z. B. wenn sie als Piezoaktoren realisiert sind, häufig erheblich größere Betriebsspannungsbereiche haben, z. B. mehrere 1000 Volt, kann durch die Nachschaltung eines Leistungsverstärkers der Ausgangsspannungsbereich des Operationsverstärkers an den Betriebsspannungsbereich des elektromechanischen Wandlers angepasst werden, ohne dass Spezial-Operationsverstärker mit höherem Betriebsspannungsbereich eingesetzt werden müssen. Solche SpezialOperationsverstärker mit erhöhtem Betriebsspannungsbereich, z. B. mehrere 100 Volt, sind zwar erhältlich, aber erheblich teurer als einfache Operationsverstärker mit üblicher +/-15 Volt-Versorgung. Abhilfe schafft der Leistungsverstärker, der z. B. als Gegentakt-Verstärker in entsprechender Transistorschaltung aufgebaut werden kann, wobei wiederum relativ preisgünstige handelsübliche Bauteile eingesetzt werden können.

Gemäß einer vorteilhaften Weiterbildung der Erfindung ist vorgesehen, dass die Schaltungsanordnung aus dem wenigstens einen elektromechanischen Wandler und der elektronischen Schaltung wenigstens sechs getrennte elektrische Energieversorgungsanschlüsse zur elektrischen Energieversorgung der Schaltungsanordnung mit wenigstens sechs unterschiedlichen elektrischen Potentialen aufweist. Dies ermöglicht die Verwendung weiterer Bauteile der elektronischen Schaltung, die auf anderen Spannungsniveaus mit elektrischer Energie zu versorgen sind als bereits erläuterte Bauteile wie z. B. der differenzielle Verstärker. So kann z. B. ein dem differenziellen Verstärker nachgeschalteter Leistungsverstärker auf hohem Betriebsspannungsniveau, z. B. mehrere 1000 Volt, betrieben werden, während der differenzielle Verstärker im Betriebsspannungsbereich von z. B. +15 Volt/-15 Volt betrieben wird. Dies hat den Vorteil, dass durch die sechs unterschiedlichen elektrischen Potentiale jeweils dem Spannungsniveau angepasste, einfach aufgebaute Bauteile und Schaltungen verwendet werden können, ohne dass besondere Spezialbauteile erforderlich sind. Es kann eine entsprechende Anpassung der Netzwerke auf die jeweilige Anwendung im jeweiligen Betriebsspannungsbereich vorgenommen werden.

Insbesondere kann vorgesehen sein, dass die elektronische Schaltung fünf der genannten sechs Energieversorgungsanschlüsse aufweist, um aus fünfen der genannten sechs Potentiale mit elektrischer Energie versorgt zu werden, und der elektromechanische Wandler mit einem seiner Anschlüsse an die elektronische Schaltung und mit einem anderen seiner Anschlüsse an den verbleibenden der genannten sechs Energieversorgungsanschlüsse angeschlossen ist, um aus dem verbleibenden der genannten sechs Potentiale mit elektrischer Energie versorgt zu werden.

Hierbei kann ein erster elektrischer Energieversorgungsanschluss der sechs elektrischen Energieversorgungsanschlüsse mit einem ersten elektrischen Potential verbunden sein, ein zweiter elektrischer Energieversorgungsanschluss mit einem zweiten Potential, ein dritter elektrischer Energieversorgungsanschluss mit einem dritten elektrischen Potential, ein vierter elektrischer Energieversorgungsanschluss mit einem vierten elektrischen Potential, ein fünfter Energieversorgungsanschluss mit einem fünften elektrischen Potential und der sechste elektrische Energieversorgungsanschluss mit dem sechsten elektrischen Potential.

Die elektronische Schaltung ist generell zur Dissipation des vom elektromechanischen Wandler abgegebenen elektrischen Signals eingerichtet. Die Dissipation des elektrischen Signals bzw. der darin enthaltenen elektrischen Energie kann z. B. in Form von Wärme erfolgen, z. B. über einen ohmschen Widerstand. Die Dissipation des elektrischen Signals kann auch derart erfolgen, dass die elektrische Energie zum Aufladen eines Akkumulators oder zum Betreiben eines anderen elektrischen Geräts verwendet wird.

Gemäß einer vorteilhaften Weiterbildung der Erfindung ist die elektronische Schaltung als breitbandig Impedanz-angepasstes Dämpfungsnetzwerk ausgebildet. Die elektronische Schaltung ist damit breitbandig, z. B. in einem Frequenzbereich von 0 bis 5 Kilohertz oder von 0 bis 10 Kilohertz. Die Impedanzanpassung erfolgt dabei an die Eingangsimpedanz des elektromechanischen Wandlers. Dies hat den Vorteil, dass mittels des semiaktiven Schwingungsdämpfungselements eine effiziente Schwingungsdämpfung in einem großen Frequenzbereich ermöglicht ist.

Gemäß einer vorteilhaften Weiterbildung der Erfindung ist die elektronische Schaltung als negativer Impedanzkonverter, z.B. als negatives Kapazitätsnetzwerk, oder als synthetischer Schwingkreis, als synthetische Induktivität oder als Gyrator ausgebildet. Die Realisierung eines negativen Kapazitätsnetzwerks hat den Vorteil, dass eine sehr breitbandige Impedanzanpassung auf einfache und kostengünstige Weise, d. h. mit wenigen Bauteilen, realisiert werden kann. Dadurch ist dieser Netzwerktyp für die Anwendung bei veränderlichen Parametern und breitbandiger mechanischer Anregung besonders geeignet. Es eignen sich auch synthetische Schwingkreise oder synthetische Induktivitäten, die im Gegensatz zu "normalen" Schwingkreisen bzw. Induktivitäten durch eine mit Halbleiterbauelementen ausgebildete elektronische Schaltung nachgebildet werden, z. B. durch eine Operationsverstärker-Schaltung. Auch eignet sich ein Gyrator, der den Vorteil hat, bei kapazitiver Ausgangsbelastung ein induktives Eingangsverhalten zu zeigen. Der Gyrator kann z. B. als aktive elektronische Schaltung realisiert werden, z. B. in Form eines negativen Impedanzkonverters. Die genannten Schaltungen eignen sich besonders für eine Ausbildung des elektromechanischen Wandlers als piezoelektrischer Aktuator, da der piezoelektrische Aktuator sich in elektrischer Hinsicht wie eine Kapazität verhält.

Die Erfindung wird nachfolgend anhand von Ausführungsbeispielen unter Verwendung von Zeichnungen näher erläutert.

Es zeigen:

Figur 1 - Eine erste Ausführungsform eines semiaktiven Schwingungsdämpfungselements und

Figur 2 - eine zweite Ausführungsform eines semiaktiven Schwingungsdämpfungselements und

Figur 3 - eine dritte Ausführungsform eines semiaktiven Schwingungsdämpfungselements.

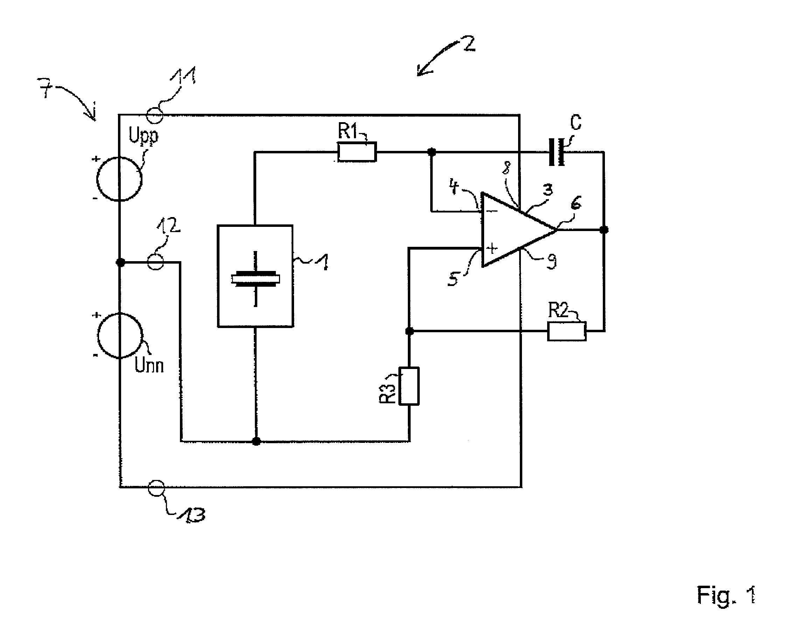

Die semiaktiven Schwingungsdämpfungselemente gemäß den Figuren 1 bis 3 werden schematisch in Form von elektrischen Schaltbildern dargestellt. In den Figuren werden gleiche Bezugszeichen für einander entsprechende Elemente und Signale verwendet.

Die Figuren 1 bis 3 zeigen Realisierungen der elektronischen Schaltung beispielhaft jeweils in Form eines negativen Kapazitätsnetzwerks. Die zuvor erwähnten Alternativen wie z. B. ein Gyrator können gleichermaßen realisiert werden.

Die Figur 1 zeigt ein semiaktives Schwingungsdämpfungselement, das einen elektromechanischen Wandler 1 in Form eines Piezoaktuators sowie eine mit dem elektromechanischen Wandler 1 elektrisch verbundene elektronische Schaltung 2 aufweist. Die elektronische Schaltung 2 weist einen differenziellen Verstärker auf 6, z. B. einen Operationsverstärker, der mit weiteren passiven Bauelementen nach Art eines Dämpfungsnetzwerks verbunden ist. Der differenzielle Verstärker 6 weist zwei differenzielle Eingänge 4, 5 auf. Ein erster Eingang ist als Negativ-Eingang 4 ausgebildet, ein zweiter Eingang als Positiv-Eingang 5. An einem Ausgang 6 des differenziellen Verstärkers 3 wird die Differenz zwischen dem am Positiv-Eingang 5 und dem am Negativ-Eingang 4 anliegenden Spannungspotential mit einem gewissen Verstärkungsfaktor spannungsverstärkt als Ausgangssignal bereitgestellt. Das Ausgangssignal des differenziellen Verstärkers 6 wird über weitere Bauelemente dem elektromechanischen Wandler 1 als Beaufschlagungssignal zugeführt, wie noch erläutert wird.

Der Negativ-Eingang 4 des differenziellen Verstärkers 3 ist mit einem ersten ohmschen Widerstand R1 und einem Kondensator C verbunden. Der Positiv-Eingang 5 des differenziellen Verstärkers 3 ist mit einem zweiten ohmschen Widerstand R2 und einem dritten ohmschen Widerstand R3 verbunden. Der Ausgang 6 des differenziellen Verstärkers 3 ist mit dem zweiten ohmschen Widerstand R2 und dem Kondensator C verbunden. Der erste ohmsche Widerstand R1 ist mit einem ersten Anschluss des elektromechanischen Wandlers 1 verbunden. Der dritte ohmsche Widerstand R3 ist mit einem zweiten Anschluss des elektromechanischen Wandlers 1 sowie mit einem zweiten Energieversorgungsanschluss 12 der elektronischen Schaltung 2 verbunden.

Durch die erläuterten Bauteile R1, R2, R3, C wird zusammen mit dem differenziellen Verstärker 3 ein negatives Kapazitätsnetzwerk realisiert.

Die elektronische Schaltung 2, aufweisend den differenziellen Verstärker 3 sowie die Bauteile R1, R2, R3 und C, weist drei getrennte elektrische Energieversorgungsanschlüsse 11, 12, 13 auf, über die die gesamte Schaltungsanordnung mit elektrischer Energie zu deren Betrieb versorgt wird. Ein erster elektrischer Energieversorgungsanschluss 11 ist mit einem ersten elektrischen Potential verbunden. Ein zweiter elektrischer Energieversorgungsanschluss 12 ist mit einem zweiten elektrischen Potential verbunden. Ein dritter elektrischer Energieversorgungsanschluss 13 ist mit einem dritten elektrischen Potential verbunden. Die drei elektrischen Potentiale werden durch eine Energieversorgungseinrichtung 7 bereitgestellt, die aus zwei in Reihe geschalteten Spannungsquellen Upp, Unn besteht. Die Spannungsquellen Upp, Unn können durch ein oder mehrere Netzteile, Batterien oder Akkumulatoren realisiert werden.

Ein positiver Energieversorgungsanschluss 8 des differenziellen Verstärkers 3 ist mit dem am ersten Energieversorgungsanschluss 11 anliegenden elektrischen Potential verbunden. Ein negativer elektrischer Energieversorgungsanschluss 9 des differenziellen Verstärkers 3 ist mit dem am dritten Energieversorgungsanschluss 13 anliegenden elektrischen Potential verbunden. Das in der Mitte zwischen den zwei Spannungsquellen Upp, Unn vorliegende Potential liegt zwischen den an den elektrischen Energieversorgungsanschlüssen 11, 13 anliegenden Potentialen und ist mit dem zweiten elektrischen Energieversorgungsanschluss 12 verbunden. Das am zweiten elektrischen Energieversorgungsanschluss 12 anliegende zweite elektrische Potential kann zum Beispiel ein Bezugspotential der gesamten Schaltungsanordnung sein, zum Beispiel ein Massepotential. Die Spannungsquellen Upp, Unn können z.B. Spannung in der gleichen Höhe bereitstellen, z.B. jeweils 15 Volt.

In der Schaltungsanordnung gemäß Figur 1 wird der elektromechanische Wandler 1 mit Bezug auf dasselbe Bezugspotential am zweiten elektrischen Energieversorgungsanschluss 12 betrieben wie der differenzielle Verstärker 3. Das über den Ausgang 6 erzeugte Ausgangssignal und über den Kondensator C und den Widerstand R1 dem ersten Anschluss des elektromechanischen Wandlers als Beaufschlagungssignal zugeführte Spannungssignal ist daher im Wesentlichen symmetrisch zum Bezugspotential am zweiten Energieversorgungsanschluss 12, das heißt es weist gegenüber diesem Bezugspotential einen Gleichspannungsanteil von null Volt auf. Dementsprechend ist die anhand der Figur 1 beschriebene Schaltungsanordnung besonders vorteilhaft für elektromechanische Wandler, die einen symmetrischen Betriebsspannungsbereich aufweisen, oder wenn durch das Ausgangssignal des differenziellen Verstärkers 6 der Betriebsspannungsbereich nicht voll ausgenutzt wird, so dass das symmetrische Beaufschlagungssignal innerhalb des zulässigen Betriebsspannungsbereich des elektromechanischen Wandlers 1 liegt.

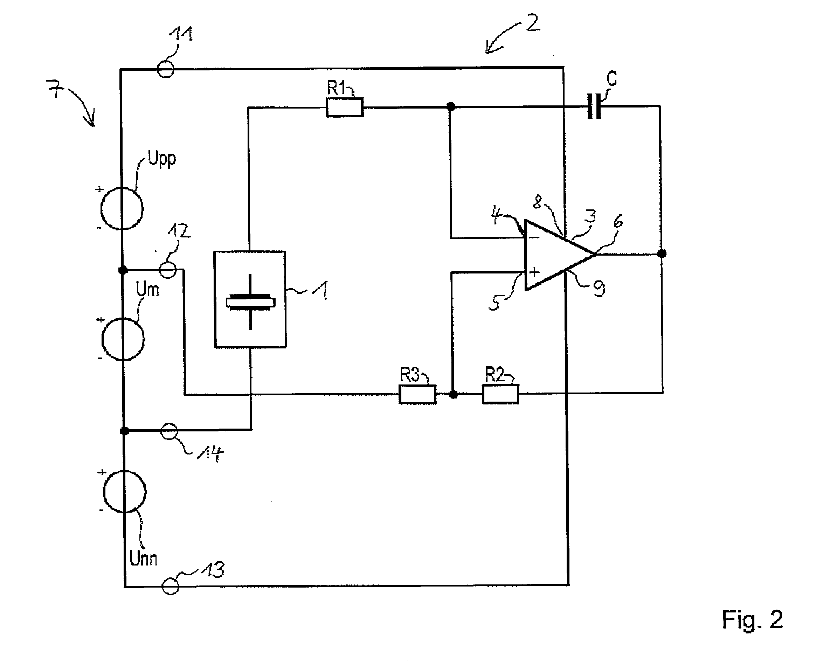

Die Figur 2 zeigt eine zweite Ausführungsform des semiaktiven Schwingungsdämpfungselements, wobei mit gleichen Bezeichnungen versehene Elemente denen der Figur 1 entsprechen. Im Unterschied zur Figur 1 weist die Energieversorgungseinrichtung 7 eine dritte Spannungsquelle Um auf, die in Reihe zu den Spannungsquellen Upp, Unn angeordnet ist und zwischen diesen geschaltet ist. Durch die drei in Reihe geschalteten Spannungsquellen Upp, Um, Unn können vier unterschiedliche elektrische Potentiale bereitgestellt werden.

Ein weiterer Unterschied zur Ausführungsform gemäß Figur 1 ist, dass die Schaltungsanordnung aus dem elektromechanischen Wandler 1 und den übrigen Bauteilen 3, R1, R2, R3, C der elektronischen Schaltung 2 insgesamt vier getrennte elektrische Energieversorgungsanschlüsse 11, 12, 13, 14 aufweist, nämlich die zuvor bereits erläuterten ersten, zweiten und dritten Energieversorgungsanschlüsse 11, 12, 13 sowie einen vierten Energieversorgungsanschluss 14, der getrennt von den übrigen Energieversorgungsanschlüssen 11, 12, 13 ist. Der elektromechanische Wandler 1 ist mit einem zweiten Anschluss allein mit dem vierten Energieversorgungsanschluss 14 verbunden, und nicht wie gemäß Figur 1 noch mit dem dritten ohmschen Widerstand R3. Der dritte ohmsche Widerstand R3 ist nach wie vor mit dem zweiten Energieversorgungsanschluss 12 verbunden. Durch die beschriebene Schaltungsanordnung liegt der zweite Anschluss des elektromechanischen Wandlers 1 nun nicht mehr auf demselben Bezugspotential wie der differenzielle Verstärker 3. Als Bezugspotential kann zum Beispiel das am zweiten Energieversorgungsanschluss 12 anliegende Potential gesehen werden. Alternativ kann auch das am vierten Energieversorgungsanschluss 14 anliegende Potential oder irgendein anderes Potential als Bezugspotential angesehen werden. Durch die Schaltungsanordnung kann in einfacher Weise die elektronische Schaltung 2 dazu eingerichtet sein, den elektromechanischen Wandler 1 mit einem Beaufschlagungssignal zu beaufschlagen, dessen Gleichspannungsanteil ungleich null Volt ist. Der Gleichspannungsanteil entspricht dann nämlich der Potentialdifferenz zwischen dem zweiten elektrischen Energieversorgungsanschluss 12 und dem vierten Energieversorgungsanschluss 14, also der Spannung der Spannungsquelle Um.

Die Spannungen der Spannungsquellen der elektrischen Energieversorgungseinrichtung 7 können beispielhaft für einen elektromechanischen Wandler in Form eines Piezoaktuators mit einem ein Millimeter dicken Piezoelement, das einen zulässigen Betriebsspannungsbereich von -500 Volt bis +2.000 aufweist, wie folgt angegeben werden:

Upp = 1.250 Volt, Um = 750 Volt, Unn = 500 Volt.

Mit einer solchen Schaltungsanordnung kann der zulässige Betriebsspannungsbereich des Piezoaktuators 1 voll ausgenutzt werden, ohne dass die Unsymmetrie dessen Betriebsspannungsbereiches hinderlich ist.

Eine Überschreitung des zulässigen Betriebsspannungsbereichs kann bei elektromechanischen Wandlern in Form Piezoaktuatoren zu einer Schädigung führen. Bei einer Überschreitung des negativen Grenzwertes des Betriebsspannungsbereiches kommt es zu einer Umpolarisation der Piezokeramik, die die Dehnungsrichtung umkehrt. Eine ständige Umpolarisation des Piezokristalls würde zu starker Erwärmung und zu Rissbildung und damit letztendlich zur Zerstörung des Piezoaktuators führen.

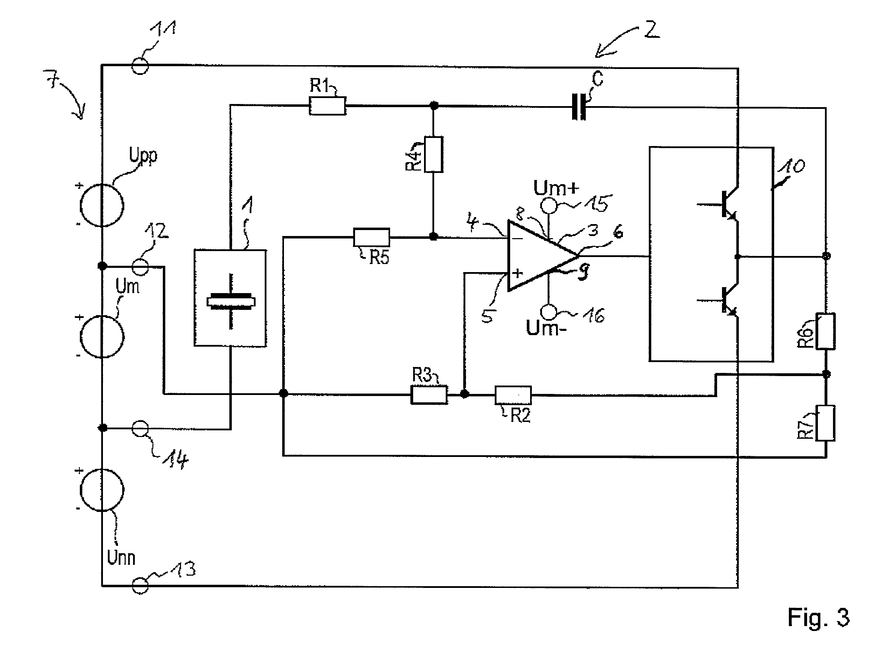

Die Figur 3 zeigt eine dritte Ausführungsform des semiaktiven Schwingungsdämpfungselements, wobei mit gleichen Bezeichnungen versehene Elemente denen der Figur 1 bzw. 2 entsprechen. Im Unterschied zur Figur 2 weist die elektronische Schaltung zusätzlich einen Leistungsverstärker 10 auf, der dem differenziellen Verstärker 3 nachgeschaltet ist. Das am Ausgang 6 des differenziellen Verstärkers 3 abgegebene Ausgangssignal wird direkt dem Leistungsverstärker 10 zugeführt und an dessen Ausgang an den Kondensator C sowie an einen sechsten ohmschen Widerstand R6 abgegeben. Der Leistungsverstärker 10 wird direkt mit elektrischer Energie von dem ersten elektrischen Energieversorgungsanschluss 11 und dem dritten elektrischen Energieversorgungsanschluss 13 versorgt, also bei den zuvor beispielhaft angegebenen Spannungswerten der Spannungsquellen Upp, Um, Unn mit +2000 Volt und - 500 Volt, wenn man das am vierten elektrischen Energieversorgungsanschluss 14 anliegende Potential als Bezugspotential ansieht. Wie erkennbar ist, wird der Leistungsverstärker 10 insgesamt mit sehr hoher Betriebsspannung betrieben, die dem Betriebsspannungsbereich des elektromechanischen Wandlers 1 entspricht.

Im Unterschied zu der Ausführungsform gemäß Figur 2 wird der differenzielle Verstärker 3 aus anderen Spannungsquellen mit elektrischer Energie versorgt. Der positive Energieversorgungsanschluss 8 des differenziellen Verstärkers 3 ist mit einem fünften elektrischen Energieversorgungsanschluss 15 verbunden, an dem als fünftes Potential eine positive Versorgungsspannung Um+ anliegt. Der negative Energieversorgungsanschluss 9 ist mit einem sechsten elektrischen Energieversorgungsanschluss 16 verbunden, an dem als sechstes Potential eine negative Versorgungsspannung Um- anliegt. Durch die beschriebene Schaltungsanordnung können die Betriebsspannungsniveaus des Leistungsverstärkers 10 und des differenziellen Verstärkers 3 voneinander entkoppelt werden. Dies hat den Vorteil, dass als differenzieller Verstärker zum Beispiel einfache, kostengünstig erhältliche Operationsverstärker mit üblicher +15 Volt/-15 Volt-Versorgung eingesetzt werden können. So kann die positive Versorgungsspannung Um+ zum Beispiel +15 Volt betragen, die negative Versorgungsspannung UM- kann -15 Volt betragen.

Die an dem fünften elektrischen Energieversorgungsanschluss und dem sechsten elektrischen Energieversorgungsanschluss anliegenden Potentiale sind vorteilhaft symmetrisch zu einem Bezugspotential des differenziellen Verstärkers 3 ausgelegt, das dem Potential am zweiten elektrischen Energieversorgungsanschluss 12 entspricht.

Die beschriebene Schaltungsanordnung mit den zwei Betriebsspannungsbereichen erfordert weitere Anpassungen der Rückführung der Signale auf die differenziellen Eingänge 4, 5 des differenziellen Verstärkers 3. Im Unterschied zur Ausführungsform gemäß Figur 2 ist der Negativ-Eingang 4 nicht direkt mit dem ersten ohmschen Widerstand R1 verbunden, sondern über eine erste Spannungsteilerschaltung aus einem vierten ohmschen Widerstand R4 und einem fünften ohmschen Widerstand R5. Der Positiv-Eingang 5 ist über den zweiten ohmschen Widerstand R2 nicht direkt mit dem Ausgang des Leistungsverstärkers 10 verbunden, sondern über eine zweite Spannungsteilerschaltung aus dem sechsten ohmschen Widerstand R6 und einem siebten ohmschen Widerstand R7.

Die Schaltungsanordnung gemäß Figur 3 erlaubt einen Betrieb von Piezoaktuatoren 1 in deren vollem Betriebsspannungsbereich mit einfachen und kostengünstigen Bauelementen. Durch den ersten und zweiten Spannungsteiler werden die hohen Spannungsniveaus des Leistungskreises, der durch den Leistungsverstärker 10 betrieben wird, auf die Spannungsniveaus umgeformt, mit denen der differenzielle Verstärker 3 betrieben wird.

Für die in den Figuren 1 und 2 beispielhaft genutzte serielle negative Kapazitätsschaltung kann die Impedanz, die an dem elektromechanischen Wandler 1 anliegt, mit folgender Gleichung (1) bestimmt werden:

$$Zs = \frac{R3}{R2} \ \frac{1}{sC} \qquad\qquad (1)$$

Für die erweiterte Schaltung nach Figur 3 mit den Spannungsteilern R4 und R5 sowie R6 und R7 kann ebenfalls eine Wechselspannungsanalyse durchgeführt werden. Da die beispielhafte Schaltung aufgrund der hohen Impedanzen der Signale an R4 und R5 sowie dem Spannungsteiler aus R6 und R7 keine direkte Umsetzung erlaubt, können and diesen Stellen Spannungsfolger als Impedanzwandler eingesetzt werden. Nach einigen Umformungen ergibt sich die Impedanz der Schaltung folgender Gleichung (2):

$$Zs = -\frac{1}{sC} \ \frac{R3\left(\dfrac{R7}{R6+R7}\right)}{R3\left(\dfrac{R5}{R4+R5} - \dfrac{R7}{R6+R7}\right) + R2\left(\dfrac{R5}{R4+R5}\right)} \qquad\qquad (2)$$

Bei geeigneter Wahl der Widerstände R3 bis R7 ist das Grundverhalten das gleiche, wie in Gleichung (1) dargestellt. Im Unterschied dazu lässt sich der Betrag jedoch aus allen Widerständen R2 bis R7 abbilden. Das erlaubt, an den Eingängen Spannungen im Betriebsspannungsbereich eines Standardoperationsverstärkers zu verwenden, ohne auf die Hochspannungstauglichkeit verzichten zu müssen. Gleichwohl ermöglicht dieses Konzept Anpassungen durch Veränderung einzelner Widerstandswerte.

Die Impedanz Zs wird vorteilhaft so gewählt, dass sie der Eingangsimpedanz des elektromechanischen Wandlers 1 entspricht.

## Patentansprüche

1. Semiaktives Schwingungsdämpfungselement zur Dämpfung mechanischer Schwingungen, das wenigstens einen elektromechanischen Wandler (1), der zum Wandeln mechanischer Schwingungen in ein elektrisches Signal eingerichtet ist, und wenigstens eine elektronische Schaltung (2) aufweist, die elektrisch mit dem elektromechanischen Wandler (1) verbunden ist und zur Aufnahme des vom elektromechanischen Wandler (1) aufgrund von mechanischen Schwingungen abgegebenen elektrischen Signals eingerichtet ist, **dadurch gekennzeichnet, dass** die elektronische Schaltung (2) dazu eingerichtet ist, den elektromechanischen Wandler (1) mit einem aufgrund des elektrischen Signals des elektromechanischen Wandlers (1) generierten elektrischen Beaufschlagungssignal zu beaufschlagen, wobei das Beaufschlagungssignal einen Gleichspannungsanteil aufweist, der ungleich null Volt ist.

2. Semiaktives Schwingungsdämpfungselement nach Anspruch 1, **dadurch gekennzeichnet, dass** die elektronische Schaltung (2) dazu eingerichtet ist, das elektrische Beaufschlagungssignal als Dämpfungssignal zu generieren, durch das auf den elektromechanischen Wandler (1) einwirkende mechanische Schwingungen bedämpft sind.

3. Semiaktives Schwingungsdämpfungselement nach Anspruch 1 oder 2, **dadurch gekennzeichnet, dass** die Schaltungsanordnung aus dem wenigstens einen elektromechanischen Wandler (1) und der elektronischen Schaltung (2) wenigstens vier getrennte elektrische Energieversorgungsanschlüsse (11, 12, 13, 14) zur elektrischen Energieversorgung der Schaltungsanordnung (1, 2) mit wenigstens vier unterschiedlichen elektrischen Potentialen aufweist.

4. Semiaktives Schwingungsdämpfungselement nach Anspruch 3, **dadurch gekennzeichnet, dass** die elektronische Schaltung (2) drei der genannten vier Energieversorgungsanschlüsse (11, 12, 13, 14) aufweist, um aus dreien der genannten vier Potentiale mit elektrischer Energie versorgt zu werden, und der elektromechanische Wandler (1) mit einem seiner Anschlüsse an die elektronische Schaltung (2) und mit einem anderen seiner Anschlüsse an den vierten Energieversorgungsanschluss (14) angeschlossen ist, um aus dem vierten Potential mit elektrischer Energie versorgt zu werden.

5. Semiaktives Schwingungsdämpfungselement nach einem der vorhergehenden Ansprüche, **dadurch gekennzeichnet, dass** die elektronische Schaltung (2) wenigstens einen differentiellen Verstärker (3) aufweist, der mit einem differentiellen Eingang (4, 5) und einem Ausgang (6) über ein Schaltungsnetzwerk (R1, R2, R3, R4, R5, R6, R7, C) mit einem Anschluss des elektromechanischen Wandlers (1) gekoppelt ist.

6. Semiaktives Schwingungsdämpfungselement nach einem der vorhergehenden Ansprüche, **dadurch gekennzeichnet, dass** die elektronische Schaltung (2) wenigstens einen differentiellen Verstärker (3) aufweist und dem differenziellen Verstärker (3) ein Leistungsverstärker (10) nachgeschaltet ist, der das vom differenziellen Verstärker (3) abgegebene Signal auf höhere Spannungspegel verstärkt.

7. Semiaktives Schwingungsdämpfungselement nach einem der vorhergehenden Ansprüche, **dadurch gekennzeichnet, dass** die Schaltungsanordnung aus dem wenigstens einen elektromechanischen Wandler (1) und der elektronischen Schaltung (2) wenigstens sechs getrennte elektrische Energieversorgungsanschlüsse (11, 12, 13, 14, 15, 16) zur elektrischen Energieversorgung der Schaltungsanordnung (1, 2) mit wenigstens sechs unterschiedlichen elektrischen Potentialen aufweist.

8. Semiaktives Schwingungsdämpfungselement nach Anspruch 7, **dadurch gekennzeichnet, dass** die elektronische Schaltung (2) fünf der genannten sechs Energieversorgungsanschlüsse (11, 12, 13, 14, 15, 16) aufweist, um aus fünfen der genannten sechs Potentiale mit elektrischer Energie versorgt zu werden, und der elektromechanische Wandler (1) mit einem seiner Anschlüsse an die elektronische Schaltung (2) und mit einem anderen seiner Anschlüsse an den verbleibenden (14) der genannten sechs Energieversorgungsanschlüsse (11, 12, 13, 14, 15, 16) angeschlossen ist, um aus dem verbleibenden der genannten sechs Potentiale mit elektrischer Energie versorgt zu werden.

9. Semiaktives Schwingungsdämpfungselement nach einem der vorhergehenden Ansprüche, **dadurch gekennzeichnet, dass** der elektromechanische Wandler (1) als piezoelektrischer Aktuator oder als magnetischer Aktuator, z.B. mit einer Tauchspule, ausgebildet ist.

10. Semiaktives Schwingungsdämpfungselement nach einem der vorhergehenden Ansprüche, **dadurch gekennzeichnet, dass** die elektronische Schaltung (2) zur Dissipation des vom elektromechanischen Wandler (1) abgegebenen elektrischen Signals in Form von Wärme eingerichtet ist.

11. Semiaktives Schwingungsdämpfungselement nach einem der vorhergehenden Ansprüche, **dadurch gekennzeichnet, dass** die elektronische Schaltung (2) als breitbandig Impedanz-angepasstes Dämpfungsnetzwerk ausgebildet ist.

12. Semiaktives Schwingungsdämpfungselement nach einem der vorhergehenden Ansprüche, **dadurch gekennzeichnet, dass** die elektronische Schaltung (2) als negativer Impedanzkonverter, z.B. als negatives Kapazitätsnetzwerk, oder als Gyrator ausgebildet ist.

Fig. 1

Fig. 2

EP 2 775 614 A2

Fig. 3

EP 2 775 614 A2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4158787 A
- US 5558477 A